Europäisches Patentamt

European Patent Office

Office européen des brevets

(11) Publication number: **0 040 893**

**B1**

(12) **EUROPEAN PATENT SPECIFICATION**

(45) Date of publication of patent specification: **17.04.85**

(21) Application number: **81200577.5**

(22) Date of filing: **27.05.81**

(51) Int. Cl.⁴: **B 41 N 1/22, B 41 C 1/18**

(54) Method and apparatus for applying in a closely fitting way a covering sheet on a rigid cylinder for obtaining a printing cylinder.

(30) Priority: **28.05.80 NL 8003073**

(43) Date of publication of application:
**02.12.81 Bulletin 81/48**

(45) Publication of the grant of the patent:
**17.04.85 Bulletin 85/16**

(84) Designated Contracting States:
**AT BE CH DE FR GB IT LI LU NL SE**

(56) References cited:
**CH-A- 405 842**
**DE-A-1 652 452**
**FR-A- 953 449**
**FR-A-2 391 072**
**GB-A-2 017 570**

(73) Proprietor: **STORK SCREENS B.V.**
**Raamstraat 3**
**NL-5831 AT Boxmeer (NL)**

(72) Inventor: **van der Velden, Hendricus Johannes**
**9 Dukatendreef**
**NL-5431 RN Cuyk (NL)**

(74) Representative: **Mathol, Heimen et al**
**EXTERPATENT Willem Witsenplein 4**
**NL-2596 BK 's-Gravenhage (NL)**

# Description

The present invention relates to a method for applying in a closely fitting way a covering sheet with a thermoplastic elastomeric composition and hardenable by exposure to light on a rigid cylinder, for obtaining a printing cylinder, in which method a sheet of said elastomeric composition is wrapped around the cylinder thereby covering the surface completely and wrapping the outside of said sheet in a flexible transparent film of gas-tight material and attaching said sheet upon said surface by application of pressure and heat.

A method of this type is known in the art, whereby a sheet of covering material is attached to the cylinder surface prior to exposure to light in such a way that the edges of the sheet which are to be joined are very close fitting to each other, which is accomplished by giving a certain shape to both edges. When the thermoplastic sheet has been wrapped around the cylinder, said sheet is attached to the cylinder surface by application of heat and pressure to the sheet, during which operation also the two edges are attached to each other.

This known method has the drawback that due to the application of mechanical pressure at relatively high temperatures, very easy an unevenness in the covering is introduced which has to be removed by subsequent grinding operations. Additionally very frequently inclusion of air between the covering layer and the cylinder surface is observed.

It is an object of the present invention to provide a method which has none of said drawbacks. According to the invention this object is obtained in that one starts from a cylinder surface comprising a pattern of interconnected superficial cavities or identations, forming continuous channels from one end of said cylinder to the other, the pressure being generated by means of vacuum at one end of said cylinder, and in that a first heating is carried out during 10—120 min. at a temperature of 100—150°C, said temperature lying between the glass transition temperature and the melting temperature of the composition, after which first heating period the vacuum is disconnected and consequently the pressure released and the flexible film is removed, whereupon a second heating is carried out during a period of 10—60 min. at a temperature of 100—150°C.

Due to the pattern of cavities or identations in the cylinder surface, a vacuum may be formed in the space between the covering and the cooperating cylinder surface, by which action the atmosphere pressure is pressing the covering firmly onto the cylinder surface. The covering is thereby adhered to the surface without the danger of air inclusions between the covering and the cylinder surface. By maintaining a vacuum in the space between the cylinder surface and the covering, gases or vapors which would otherwise accumulate in said space are removed, resulting in an optimal adhesion.

A further advantage of such a method consists in that the covering is applied without tension and that accordingly an eventual plastic memory effect of the covering is not observed. Due to this, less wear problems and less problems relating to the seam formed joining the edges of the sheet of elastomeric composition, are observed.

It is observed that DE—A—14 47 874 describes a method for covering a cylinder surface with a thermoplastic elastomeric composition adapted to be hardened by exposure to light, in which method a sheet of said elastomeric composition is wrapped around the cylinder thereby covering the surface completely and wrapping the outer side of said sheet in a flexible transparent film of gas-tight material and subsequently attaching said sheet upon said surface by application of heat and a vacuum, said cylinder surface comprising a mesh screen forming continuous channels from one end of said cylinder to the other, the vacuum being connected to said channels. This known method is serving to apply a photographic pattern upon a plate, said plate being temporarily put into a cylindrical shape in order to perform the photographic operation.

In contrast to this prior art, the method according to the present invention renders it possible to manufacture a printing roller especially for flexo-printing i.e. a rigid cylinder with a rather cheap outer covering, capable of receiving a specific pattern with which a printing operation can be performed for a reduced number of copies or a limited length of a paper or textile web. The present method relates to the manner in which the covering sheet of a thermoplastic elastomeric composition is applied, adhered and firmly connected to a supporting cylindrical surface, so as to obtain a flexo-printing roller with a flexible outer covering which is strongly adhered to the support cylinder and provided with an outer surface having a smooth cylindrical form (no ups and downs), and further has uniform elastic properties along its entire periphery.

In the present method, the photopolymer sheet should during the manufacturing process, reach a temperature at which said sheet is in a condition without flow or deformation but soft enough to obtain an adherence to the surface of the support cylinder.

A suitable form of the method is further characterized in that the vacuum is applied with a maximum absolute pressure of 50 mm of mercury in the space between the outer surface of the cylinder surface and the inner side of the covering sheet, the temperature being maintained at 140°C, and said heating steps are carried out during a period of one hour and subsequently during a second period of half an hour respectively.

It is a further object of the present invention to provide an apparatus for applying in a closely fitting way a covering sheet consisting of a thermoplastic elastomeric composition and hardenable by exposure to light on a cylinder intended for use as a printing cylinder, said apparatus comprising a cylinder surface being provided with interconnected superficial channels opening towards said covering sheet, two end flanges with raised borders and means for the application of an internal vacuum to the said channels so as to press said sheet on said cylinder surface. A somewhat similar apparatus can be derived from DE—A—14 47 874 in which the superficial channels are formed by a mesh screen. According to the invention however, the apparatus aims to be more adequate for the manufacture of a printing cylinder and to that end is characterized in that said channels formed by the said cylinder surface itself extend from one end of a rigid support cylinder to the other, that both end flanges are arranged in abutting relationship with the end edges of the covering sheet and are sealed respectively by a flexible band or tape applied over the butt joints between said raised borders and said end edges of said sheet, and that said flanges further are connected to a gas exhaust tube ending in an annular space within said flanges such that said spaces are connected with the channels between the outer surface of the cylinder and the inner side of the covering sheet.

Further aims and attendant advantages will be more readily appreciated as the same becomes better understood by reference to the following detailed description and considered in connection with the accompanying drawings.

Figure 1 is a printing cylinder according to the present invention of which the covering is partially removed;

Figure 2 is a longitudinal side view of the apparatus for carrying out the method according to the invention in the situation in which the covering sheet is not yet pressed to the surface of the printing cylinder;

Figure 3 is a printing cylinder with a thin flexible material wrapped in an overlapping way around the elastomeric composition;

Figure 4 is a cross section along line IV—IV in Figure 3;

Figure 5 is a cross section through a printing cylinder according to, Figure 1.

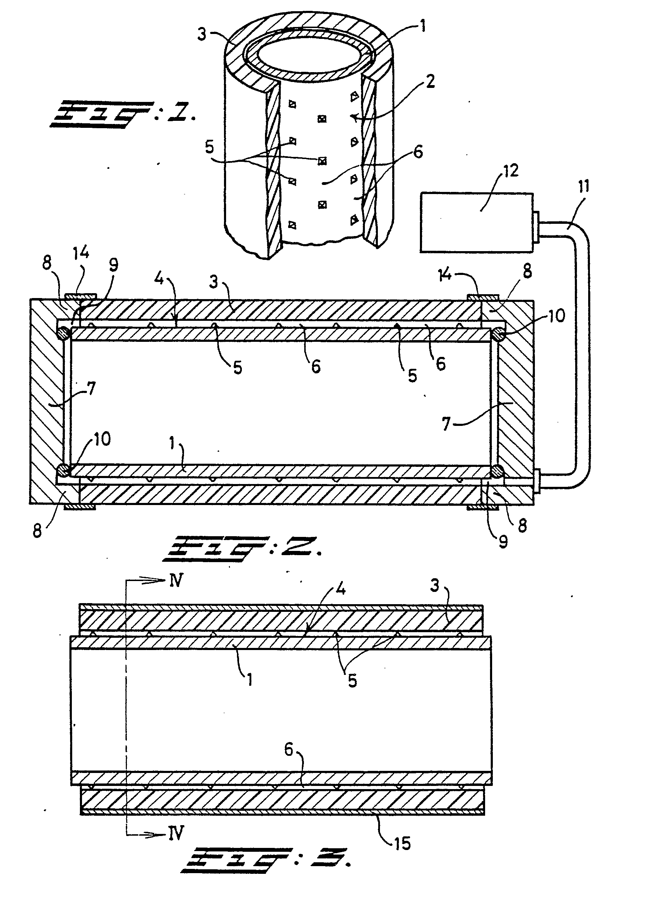

Referring now to Figure 1 on the surface 2 of a metal cylinder 1 a sheet 3 is situated of a thermoplastic elastomeric composition which can be hardened with light and on which by exposure a certain pattern may be formed which may serve for the purpose of printing. In order to ensure proper adhesion of said sheet 3 on the outside surface 4 of the metal cylinder, bulges 5 are applied which together form channels 6 which enable the removal of gases present between sheet 3 and the outside surface 4 thus ensuring optimal adhesion without air inclusions between the inside surface of sheet 3 and the outside surface 4 of the metal cylinder 1.

Instead of bulges 5 also longitudinal channels can be provided in the outside surface 4 of the metal printing cylinder 1.

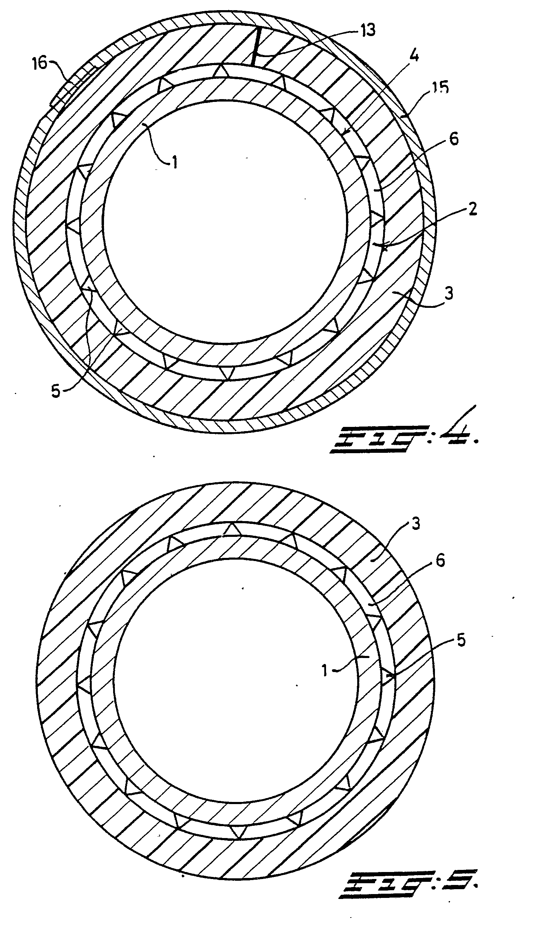

Referring now to Figure 2 an apparatus serving for the applications of said sheet 3 on the surface 4 of a metal printing cylinder 1, comprises two cylindrical flanges 7 with a cylindrical raised border 8. In the flanges concentric channels 9 are formed which are sealed with an O-ring 10. These annular channels 9 are connected to a vacuum source 12 via tube 11. At the outside surface of the cylinder 1, the sheet 3 of a thermoplastic elastomeric composition which can be hardened by light is applied, such that both edges 13 contact each other. On the outer side of said sheet a pattern for printing purposes may be applied by exposure to light. After application of sheet 3 adhesive tape 14 is applied covering the outside of the end-part of sheet 3 and the raised border 8 of flanges 7. Channel 9 is formed in such a way that the available clearance in the form of channels 6 is connected with the said channel 9. After application of adhesive tape 14, gas present between the outside surface 4 of cylinder 1 and the inside surface of sheet 3 is removed by suction; subsequently cylinder surface 4 of cylinder 1 is heated. Heating is carried out during 10 to 120 min.; preferably during 10—60 min. at a temperature of 100°—150°C. In order to ensure an optimal attachment of said sheet of light hardenable thermoplastic elastomeric composition on the outer surface 4 of printing cylinder 1, after application of sheet 3, a thin foil 15 is wrapped around the entire periphery of cylinder 1 and sheet 3, which foil suitably consists of polyvinylchloride with a thickness of 2½—25 microns, preferably of 15 microns. Overlap 16 is situated a good distance from the area where edges 13 of sheet 3 contact each other.

By maintaining the exhaust of gases via tube 11 and vacuum source 12 during the heating operation, also gases which are developed during said heating are removed, so ensuring an optimal adhesion between sheet 3 and surface 4 of cylinder 1.

The invention will now be explained more in detail in the following example.

Example

A metal cylinder 1 with a surface 4 comprising longitudinally applied channels 6 which are formed by notches 5 on the outside of the cylinder, is covered with a sheet 3 of a thermoplastic elastomeric composition which may be hardened by exposure to light (Cyrel of DuPont). Edges 13 of sheet 3 are contacting each other in a close fitting way. The whole assembly is subsequently mounted between the flanges 7 of the apparatus as outlined above. By generating a vacuum of an absolute pressure of a maximum of 50 mm of mercury, preferably 20 mm, gases present between sheet 3 and surface 4 are removed. Subsequently the whole assembly is wrapped with a polyvinylchloride foil with a thickness of 15 micrometer. After this the cylinder is heated to a temperature of 140°C; said heating lasting for one hour. Subsequently exhaust via vacuum source 12 is ended, the wrapping foil 15 is removed after which another heating at 140°C during half an hour is carried out. Upon application of wrapping foil 15 of polyvinylchloride, care is taken to situate overlapping parts 16 at a good distance from the seam which is formed by edges 13 of sheet 3. The whole is subsequently cooled and a printing cylinder is obtained which is optimally united with sheet 3; after this sheet 3 can be processed to obtain the desired printing pattern.

The cylinder 1 of the apparatus may be provided at both ends with a separate ring (not shown) being located close to the cylinder 1 and having an outer diameter which corresponds to that of the said cylinder. The coating or sheet 3 must have a width such, that both additional rings are covered.

After the completion of the manufacturing process, both rings with their annular covering are discarded, thus eliminating the side edges of the printing cylinder. These side edges have appeared to possess a slightly increased thickness, which should be avoided in a printing cylinder.

### Claims

1. Method for applying in a closely fitting way a covering sheet with a thermoplastic elastomeric composition and hardenable by exposure to light on a rigid cylinder, for obtaining a printing cylinder, in which method a sheet of said elastomeric composition is wrapped around the cylinder thereby covering the surface completely and wrapping the outerside of said sheet in a flexible transparent film of gas-tight material and attaching said sheet upon said surface by application of pressure and heat, characterized in that one starts from a cylinder surface comprising a pattern of interconnected superficial cavities or indentations, forming continuous channels from one end of said cylinder to the other, the pressure being generated by means of a vacuum at one end of said cylinder, and in that a first heating is carried out during 10—120 min. at a temperature of 100—150°C, said temperature lying between the glass transition temperature and the melting temperature of the composition, after which first heating period the vacuum is disconnected and consequently the pressure released and the flexible film is removed, whereupon a second heating is carried out during a period of 10—60 min. at a temperature of 100—150°C.

2. Method according to claim 1, characterized in that said vacuum is applied with a maximum absolute pressure of 50 mm of mercury in the space between the outer surface of the cylinder surface and the inner side of the covering sheet, the temperature being maintained at 140°C, and said heating steps are carried out during a period of one hour and subsequently during a second period of half an hour respectively.

3. Apparatus for applying in a closely fitting way a covering sheet consisting of a thermoplastic elastomeric composition and hardenable by exposure to light on a cylinder intended for use as a printing cylinder, said apparatus comprising a cylinder surface (4) being provided with interconnected superficial channels (6) opening towards said covering sheet, two end flanges (7) with raised borders (8) and means for the application of an internal vacuum to the said channels so as to press said sheet on said cylinder surface, characterized in that said channels formed by the said cylinder surface itself extend from one end of a rigid support cylinder (1) to the other, that both end flanges (7) are arranged in abutting relationship with the end edges of the covering sheet (3) and are sealed respectively by a flexible band or tape (14) applied over the butt joints between said raised borders (8) and said end edges of said sheet (3), and that said flanges further are connected to a gas exhaust tube (11) ending in an annular space (9) within said flanges such that said spaces are connected with the channels (16) between the outer surface (4) of the cylinder (1) and the inner side of the covering sheet (3) (Fig. 2).

4. Apparatus according to claim 3, characterized in that the cylinder (1) is provided with a separate ring at both ends of the cylinder, said rings being located close to said cylinder and having an outer diameter equal to the diameter of the cylinder, the covering sheet (3) extending over both rings.

### Revendications

1. Procédé pour appliquer de façon serrée, une enveloppe de composition thermoplastique élastomère durcissant par exposition à la lumière, sur un cylindre rigide pour obtenir un cylindre d'impression, dans lequel une feuille de ladite composition élastomère entoure complètement le cylindre de façon à couvrir la surface entière de celui-ci et dans laquelle l'extérieur de cette feuille est couvert d'un film souple et transparent en matière étanche aux gaz, ladite feuille étant fixée sur ladite surface par l'application de pression et de chaleur, caractérisé en ce qu'on part d'une surface de cylindre comprenant un réseau de cavités ou de creux superficiels reliés entre eux et qui constituent des canaux allant d'une extrémité dudit cylindre à l'autre, la pression étant engendrée au moyen d'un vide à une extrémité dudit cylindre et en ce qu'un premier traitement thermique de 10—120 minutes et à une température de 100—150°C est effectué, ladite température étant située entre le point de transition du verre et le point de fusion du composé. Après cette première période de traitement thermique, la source de vide est débranchée, la pression diminue par conséquent et le film souple est enlevé, après quoi l'on effectue un deuxième traitement thermique de 10—60 minutes à une température de 100—150°C.

2. Procédé selon la revendication 1, caractérisé en ce que ledit vide est appliqué à une pression maximum absolue de 50 mm de mercure dans l'espace entre la surface extérieure du cylindre et le côté intérieur de l'enveloppe, la température étant maintenue à 140°C et ces traitements thermiques étant exécutés pendant respectivement une heure et ensuite un deuxième temps d'une demi-heure.

3. Appareil pour appliquer de façon serrée, une enveloppe en composé thermoplastique élastomère durcissant par exposition à la lumière, sur un cylindre destiné à servir de cylindre d'impression, ledit appareil contenant une surface (4) munie de canaux superficiels (6) reliés entre eux et débouchant sur ladite enveloppe, deux brides d'extrémité (7) ayant des bords (8) relevés et des moyens d'appliquer un vide interne auxdits canaux afin de fixer par pression ladite feuille sur ladite surface du cylindre, caractérisé en ce que lesdits canaux formés par ladite surface de cylindre s'étendent d'une extrémité du cylindre à l'autre, que les deux brides d'extrémité (7) viennent en appui contre les bords de l'extrémité de l'enveloppe (3) et sont respectivement connectées de façon étanche par une bande ou un ruban (14) recouvrant les joints d'about entre lesdits bords relevés (8) et lesdites extrémités de ladite feuille (3) et que lesdites brides sont en outre connectées à un tuyau d'échappement des gaz (11) débouchant dans une ouverture annulaire (9) dans lesdites brides, de telle sorte que lesdites ouvertures sont reliées aux canaux (16) entre la face extérieure (4) du cylindre (1) et le côté intérieur de l'enveloppe (3) (Fig. 2).

4. Appareil selon la revendication 3, caractérisé en ce que le cylindre (1) est muni à ses deux extrémités d'un anneau séparé, lesdits anneaux étant situés près dudit cylindre et ayant un diamètre extérieur équivalent au diamètre du cylindre, l'enveloppe (3) recouvrant les deux anneaux.

**Patentansprüche**

1. Verfahren zum festsitzenden Anbringen einer Deckfolie aus einem thermoplastischen, elastomeren Material, das durch Einwirkung von Licht härtbar ist, auf einem steifen Zylinder zwecks Herstellung eines Druckzylinders durch Wickeln einer Folie aus besagtem elastomerem Material um den Zylinder zur vollständigen Bedeckung von dessen Oberfläche und Umwickeln der Außenseite jener Folie mit einem flexiblen transparenten Film aus gasdichtem Material und Befestigen der Folie auf jener Oberfläche durch Anwendung von Druck und Hitze, dadurch gekennzeichnet, daß eine Zylinderoberfläche gewählt wird, die ein Muster aus miteinander verbundenen oberflächlichen Hohlräumen oder Vorsprünge aufweist, die durchgehende Kanäle vom einen Ende zum anderen Ende des Zylinders ausbilden, daß der Druck mit Hilfe eines Unterdruckes am einen Ende des Zylinders erzeugt wird und daß eine erste Ausheizung während 10 bis 120 Minuten bei einer Temperatur von 100 bis 150°C durchgeführt wird, die zwischen der Glasübergangstemperatur und der Schmelztemperatur des Materials liegt, anschließend der Unterdruck abgeschaltet und als Folge der Druck aufgehoben werden, der flexible Film entfernt und anschließend eine zweite Ausheizung während einer Zeitdauer von 10 bis 60 Minuten bei einer Temperatur von 100 bis 150°C durchgeführt wird.

2. Verfahren nach Anspruch 1, dadurch gekennzeichnet, daß der Unterdruck mit einem maximalen Absolutdruck von 50 mm Hg im Zwischenraum zwischen der Außenfläche des Zylinders und der Innenseite der Deckfolie angelegt wird, die Temperatur auf 140°C gehalten wird und die Ausheizzeiten eine Stunde und später eine halbe Stunde betragen.

3. Vorrichtung zum festsitzenden Anbringen einer Deckfolie aus einem thermoplastischen, elastomeren Material, das durch Einwirkung von Licht aushärtbar ist, auf einem Zylinder, der für Druckereizwecke bestimmt ist, wobei die Zylinderoberfläche (4) mit miteinander verbundenen oberflächlichen Kanälen (6) versehen ist, die sich gegen die Deckfolie öffnen, zwei Endflansche (7) mit erhöhten Rändern (8) und eine Einrichtung für die Zuführung eines Unterdrucks zu den Kanälen aufweist, um die Folie auf die Zylinderoberfläche zu drücken, dadurch gekennzeichnet, daß die Kanäle, die durch die Zylinderoberfläche selbst ausgebildet sind, sich vom einen Ende eines festen Tragzylinders (1) zum anderen Ende erstrecken, daß beide Endflansche (7) an die Ränder der Deckfolie (3) anstoßen und durch ein flexibles Band oder eine Folie (14), die über den stumpfen Anschlüssen zwischen den erhöhten Rändern (8) und den Rändern der Folie (3) angebracht sind, abgedichtet sind, und daß die Flansche weiterhin mit einer Gasabführleitung (11) versehen sind, die in einem ringförmigen Raum (9) innerhalb der Flansche endet, so daß die Zwischenräume (9) mit den Kanälen (16) zwischen der Außenfläche (4) des Zylinders (1) und der Innenseite der Deckfolie (3) verbunden sind (Fig. 2).

4. Vorrichtung nach Anspruch 3, dadurch gekennzeichnet, daß der Zylinder (1) mit getrennten Ringen an beiden Enden des Zylinders versehen ist, die dicht am Zylinder anliegen und einen Außendurchmesser haben, der gleich dem Durchmesser des Zylinders ist, und daß sich die Deckfolie (3) über beide Ringe erstreckt.

FIG:1.

FIG:2.

FIG:3.

FIG:4.

FIG:5.